Europäisches Patentamt

European Patent Office

Office européen des brevets

(19)

(11) Veröffentlichungsnummer : **0 126 242**
**B1**

(12)

# EUROPÄISCHE PATENTSCHRIFT

(45) Veröffentlichungstag der Patentschrift :
**15.06.88**

(21) Anmeldenummer : **84103319.4**

(22) Anmeldetag : **26.03.84**

(51) Int. Cl.⁴ : **G 01 R 19/165, H 02 H 3/24,
H 03 K 3/295, H 03 K 17/30**

(54) Schaltungsanordnung zur Überwachung einer Betriebsspannung.

(30) Priorität : **28.03.83 DE 3311258**

(43) Veröffentlichungstag der Anmeldung :
**28.11.84 Patentblatt 84/48**

(45) Bekanntmachung des Hinweises auf die Patenterteilung : **15.06.88 Patentblatt 88/24**

(84) Benannte Vertragsstaaten :
**CH DE FR GB IT LI SE**

(56) Entgegenhaltungen :
**DE-A- 3 130 067
DE-B- 2 154 720
DE-B- 2 307 485
US-A- 3 105 924
"The Semiconductor Memory Book", INTEL Marketing Communications, J. Wiley & Sons, New York, 1978, S. 20-37**

(73) Patentinhaber : **Siemens Aktiengesellschaft Berlin und München
Wittelsbacherplatz 2
D-8000 München 2 (DE)**

(72) Erfinder : **Belz, Achim, Ing. grad.
Pichtstrasse 1
D-8000 München 70 (DE)**

EP 0 126 242 B1

**Beschreibung**

Die Erfindung betrifft eine Schaltungsanordnung gemäß dem Oberbegriff des Patentanspruches 1.

Rechnersystem mit Speichern, insbesondere mit Speicherbausteinen in CMOS-Technik, benötigen zur Erhaltung der Daten im Speicher eine sogenannte Pufferspannung. Wenn im Rechnersystem die Betriebsspannung abgeschaltet wird, übernimmt die Pufferspannung, die vorzugsweise von einem Akku oder einer Batterie geliefert wird, die Stromversorgung der Speicherbausteine. Wenn die Betriebsspannung wieder angeschaltet wird, wird die Stromversorgung aus der Pufferspannungsquelle abgeschaltet.

Damit nur definiert Daten in den Speicherbaustein geschrieben werden können, muß bei Unterschreitung einer Mindestspannung der Betriebsspannung, bzw. bei deren Abschaltung, der Speicherbaustein gesperrt werden. Das heißt, es können keine Daten mehr eingeschrieben oder ausgelesen werden. Dazu wird eine Schaltungsanordnung zur Überwachung einer Betriebsspannung verwendet, die bei Unterbrechung bzw. Abschaltung einer Betriebsspannung den Speicherbaustein sperrt. Der Strom, der zum Sperren des Speicherbausteins nötig ist, wird von der Pufferspannungsquelle oder einer zusätzlichen Hilfsspannungsquelle geliefert.

Bisher sind für diesen Anwendungsfall analoge Schaltungen bekannt, die mit Zenerdioden, Dioden, Transistoren und Widerständen aufgebaut sind. Es gibt auch eine Vielzahl von linearen, integrierten Schaltkreisen zur Spannungsüberwachung. Die meisten Schaltungen haben im gepufferten Betrieb eine relativ hohe Stromaufnahme, oder sie arbeiten mit einer zusätzlichen Hilfsspannung. Das Ausgangssignal ist bei vielen Schaltungen nur in einem bestimmten Spannungsbereich gültig. Um eine geringe Toleranz der Umschaltschwelle zu erreichen, ist meistens ein Einzelabgleich erforderlich.

Aus der Druckschrift « The Semiconductor Memory Book », INTEL Marketing Communications, John Wiley & Sons, New York, 1978, Abschnitt « Designing Non-volatile Semiconductor Memory Systems », ist am Beispiel des Intel-Bausteins 5101 ein Speicher RAM in CMOS-Technik beschrieben, bei dem im Fall des Abschaltens oder bei Unterschreiten der Betriebsspannung unter einen Mindestwert der Baustein gesperrt und die Daten-Ein/Ausgabe unterbrochen wird. Der Baustein wird dann mit einer Pufferspannung (Batterie) versorgt, wobei die Umschaltung zwischen Betriebsspannung und Pufferspannung mittels entsprechend gepolter Dioden und/oder eines Relais erfolgt. Hierzu ist eine Schaltungsanordnung vorgesehen, welche die Betriebsspannung überwacht und die eine Spannung an ein TTL-Interface abgibt, das wiederum bei Vorhandensein dieser Spannung einem Ausgang ein Signal zum Sperren des Speicherbausteins abgibt und bei Nichtvorhandensein der Spannung ein zweites Signal abgibt, wodurch der Datenaustausch erfolgen kann.

Aus der DE-A-3 130 067 ist eine Schaltungsanordnung zur Versorgungsspannungsüberwachung für intelligente Schaltkreise bekannt, die einen durch die zu überwachende Spannung über einen Widerstand aufladbaren ersten Kondensator enthält, der über eine Diode bei Absinken der überwachten Spannung entladbar ist. Weiterhin ist ein Komparator vorgesehen, dessen einer Steuereingang mit diesem Kondensator in Verbindung steht und dessen Ausgang zur Abgabe eines Resetimpulses an die intelligenten Schaltkreise bei Unterschreiten eines vorgegebenen Wertes der überwachten Spannung vorgesehen ist. Ein Transistor, der durch den Ausgang des Komparators zum Entladen des Kondensators steuerbar ist, ist mit seiner Kollektor-Emitterstrecke parallel zum Kondensator geschaltet.

Es ist Aufgabe der Erfindung, eine Schaltungsanordnung zur Überwachung einer Betriebsspannung anzugeben, die bei Absinken der Betriebsspannung unter eine Schwellenspannung die zu versorgenden Speicherbausteine einerseits in einen definierten Zustand setzt und damit die Daten Ein-/Ausgabe der Speicherbausteine unterbricht und andererseits bei abgeschalteter Betriebsspannung aus der Pufferspannungsquelle nur einen geringen Strom zieht.

Diese Aufgabe wird erfindungsgemäß durch die im kennzeichnenden Teil des Patentanspruches 1 angegebenen Merkmale gelöst.

Da im Pufferbetrieb nur passive Bauelemente, bzw. nur Leckströme der gesperrten Transistoren die Pufferspannungsquelle belasten, ist hierbei die Stromaufnahme der erfindungsgemäßen Schaltungsanordnung sehr gering.

Da nur handelsübliche Bauteile, wie Transistoren, Dioden, Widerstände, zur Realisierung der erfindungsgemäßen Schaltungsanordnung verwendet werden, ist diese kostengünstig herzustellen. Weiter ist aus diesem Grund eine Unabhängigkeit von der Herstellung von speziellen integrierten Schaltkreisen gegeben.

Dadurch, daß eine programmierbare Zenerdiode in der ersten Schaltstufe vorgesehen ist, wird die gewünschte Schaltschwelle ohne weiteren Abgleich mit hoher Genauigkeit erreicht.

Dadurch, daß in der zweiten Schaltstufe ein weiterer Transistor vorgesehen ist, ergibt sich am Ausgang der erfindungsgemäßen Schaltungsanordnung eine Schmitt-Trigger-Funktion, d. h. die Schaltzeit ist sehr gering.

Im folgenden wird die erfindungsgemäße Schaltungsanordnung anhand eines in der Zeichnung dargestellten Ausführungsbeispieles beschrieben. Dabei zeigen

Fig. 1 die erfindungsgemäße Schaltungsanordnung,

Fig. 2 den Ein- und Ausgangsspannungsverlauf einer Betriebsspannung und

Fig. 3 den Spannungsverlauf eines Ausgangssignals der Schaltungsanordnung.

Es wird davon ausgegangen, daß die verwendeten Speicherbausteine (CMOS-RAM) einen Eingang besitzen (Chip-ENABLE), über den sie bei Anlegen eines, der logischen Eins entsprechenden Potentials, sperrbar sind. Daten können nur in oder aus diesem Speicherbaustein geschrieben bzw. gelesen werden, wenn an diesem Eingang (Chip-ENABLE) ein der logischen Null entsprechendes Potential anliegt. Es wird weiter davon ausgegangen, daß die Betriebsspannung und die Pufferspannung die gleiche Polarität besitzen.

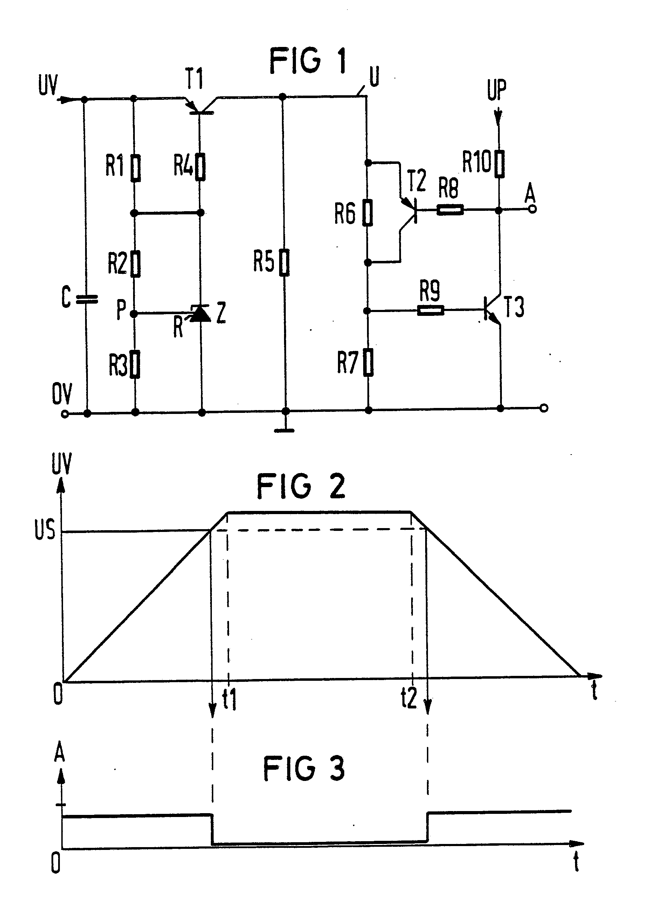

Im folgenden wird anhand von Fig. 1 der Aufbau der erfindungsgemäßen Schaltungsanordnung erläutert.

An einem Eingang UV ist die zu überwachende Betriebsspannung angeschaltet. Zwischen dem Eingang UV und einem Bezugspotential OV ist eine Parallelschaltung aus einem Kondensator C und einer Serienschaltung aus drei Widerständen R1, R2 und R3 angeschaltet, wobei der Widerstand R1 mit dem Eingang UV und der Widerstand R3 mit dem Bezugspotential OV verbunden ist. Weiter ist am Eingang UV der Emitter eines Transistors T1 angeschaltet, dessen Basis über einen Widerstand R4 und eine Zenerdiode Z mit dem Bezugspotential OV verbunden ist, wobei die Anode der Zenerdiode Z mit dem Bezugspotential OV verbunden ist. Die Zenerdiode Z ist eine einstellbare Zenerdiode, d. h. die Zenerdurchlaßspannung ist über einen Referenzeingang R einstellbar. Hier wird beispielsweise die Zenerdiode TL431M der Firma Texas Instruments verwendet. Der Referenzeingang R ist mit einem Punkt P verbunden, der sich zwischen den beiden Widerständen R2 und R3 befindet. Die Katode der Zenerdiode Z ist mit einem nicht näher bezeichneten Punkt verbunden, der sich zwischen den beiden Widerständen R1 und R2 befindet. Der Kollektor des Transistors T1 ist über einen Widerstand R5 mit dem Bezugspotential OV verbunden. Parallel zu diesem Widerstand R5 ist eine Serienschaltung aus zwei Widerständen R6 und R7 angeordnet, wobei sich der Widerstand R6 zwischen dem Emitter und dem Kollektor eines Transistors T2 befindet. Der Emitter des Transistors T2 ist also mit dem Kollektor des Transistors T1 verbunden. Der Kollektor des Transistors T2 ist über einen Widerstand R9 mit der Basis eines Transistors T3 verbunden, dessen Emitter am Bezugspotential OV angeschaltet ist. Der Kollektor des Transistors T3 ist einerseits über einen Widerstand R8 mit der Basis des Transistors T2 und andererseits über einen Widerstand R10 mit einem weiteren Eingang verbunden, an dem die Pufferspannung UP anliegt. Die Pufferspannung kann beispielsweise von einem Nic-Akku oder einer Lithiumbatterie geliefert werden. Aus dieser Pufferspannungsquelle wird auch der hier nicht dargestellte Speicherbaustein mit Strom versorgt. Ein Ausgangssignal ist an einem Ausgang A abnehmbar, der mit dem Kollektor des Transistors T3 verbunden ist. Dieser Ausgang A ist mit dem Eingang des Speicherbausteins verbunden, über den dieser sperrbar ist (Chip-ENABLE). An diesem Ausgang ist also das Signal abnehmbar, das den Zustand der zu überwachenden Betriebsspannung anzeigt.

In Fig. 2 ist der zeitliche Verlauf der am Eingang UV anliegenden Betriebsspannung dargestellt. Es wird angenommen, daß zum Zeitpunkt t = 0 die Betriebsspannung eingeschaltet wird, bis zum Zeitpunkt t = t1 ansteigt, dann konstant bleibt und zum Zeitpunkt t = t2 ausgeschaltet wird. Weiter ist eine Schwellenspannung US dargestellt. Dies ist die geringste Spannun, bei der der oder die angeschlossenen Speicherbausteine, mit der dazugehörigen logischen Schaltungsanordnung, noch sicher arbeiten.

In Fig. 3 ist der zeitliche Verlauf des am Ausgang A abnehmbaren Ausgangssignals dargestellt. In Abhängigkeit von der in Fig. 2 eingezeichneten Schwellenspannung US ändert dieses Ausgangssignal seinen Spannungswert.

Im folgenden wird die Wirkungsweise der in Fig. 1 dargestellten erfindungsgemäßen Schaltungsanordnung unter Bezugnahme auf Fig. 2 und 3 erläutert.

Beim Einschalten der Betriebsspannung steigt diese am Eingang UV von OV an. Der Widerstand R1 dient als Arbeitswiderstand für die Zenerdiode Z, d. h. zum Einstellen des Arbeitsstromes, und ist niederohmig gegenüber den Widerständen R2 und R3. Zwischen den Widerständen R2 und R3 ist am Punkt P ein Teil der am Eingang UV anliegenden Betriebsspannung abnehmbar. Dieser Teil wird auf den Referenzeingang R der Zenerdiode Z gegeben. Wenn die Spannung an diesem Punkt P einen bestimmten Vergleichswert überschreitet, wird die Zenerdiode Z von der Anode zur Katode niederohmig. Dieser Vergleichswert ist durch das Teilverhältnis der Widerstände R2 und R3 einstellbar. Das Potential an der Katode der Zenerdiode Z steigt nicht über den eingestellten Vergleichswert an. Nimmt nun die Betriebsspannung am Eingang UV einen Wert an, der größer ist als die Summe aus der Katodenspannung der Zenerdiode Z und der Basisemitterspannung der Transistors T1 (d. h. die Betriebsspannung überschreitet die Schwellenspannung US), so wird dieser leitend geschaltet. Mit dem Widerstand R4 ist der Basisstrom des Transistors T1 einstellbar. Eine Spannung U am Kollektor des Transistors T1 steigt nun schnell auf einen Wert an, der gegeben ist, durch die am Eingang UV anliegende Betriebsspannung abzüglich der Sättigungsspannung des Transistors T1. Der Widerstand R5 dient zum Einstellen des Arbeitsstromes des Transistors T1.

Die Spannung U am Kollektor des Transistors T1 steigt wesentlich schneller an, als die Betriebsspannung. Mit den Widerständen R6 und R7 wird diese Spannung U geteilt und über den Widerstand R9 der Basis des Transistors T3 zugeführt. Am Kollektor des Transistors T3 liegt über den Widerstand R10 die am Eingang UP anliegende Pufferspannung an und sperrt über den Widerstand R8 den Transistor T2. Bei einer bestimmten Spannung U am Kollektor des Transistors T1 wird die Basis-Emitter-Spannung am Transistor T3 so groß, daß dieser leitend geschaltet wird. Hierdurch wird der Ausgang A von der Pufferspannung aus gegen das Bezugspotential OV geschaltet. Ebenfalls wird hierdurch die Basis des Transistors T2 über den Widerstand R8 gegen das Bezugspotential OV gezogen, und somit wird der Transistor T2 leitend geschaltet. Am Ausgang A ist ein erster Spannungswert abnehmbar. Dieser Schaltvorgang wird dadurch beschleunigt, daß über den Transistor T2 der Widerstand R6 überbrückt wird und der Basisstrom für den Transistor T3 zusätzlich erhöht wird. Die Schleifenverstärkung in dem Kreis, der aus dem Widerstand R9 der Basiskollektorstrecke des Transistors T3, dem Widerstand R8 und der Basiskollektorstrecke des Transistors T2 bebildet wird, wird größer als Eins (d. h. die Stromänderung, beispielsweise an der Basis des Transistors T3, wird verstärkt). Das bedeutet, daß dieses System instabil wird und in eine feste Spannungslage (Transistoren T2 und T3 leitend geschaltet) kippt. Wesentlich ist hierbei, daß die am Ausgang A abgegebene Spannung, d. h. das Überwachungssignal, nicht auf einem Spannungswert zwischen der Pufferspannung und dem Bezugspotential OV stehenbleibt, sondern eine stabile Lage, d. h. einen ersten bzw. einen zweiten Spannungswert, annimmt. (Solange der Transistor T3 und auch der Transistor T2 nicht leitend geschaltet sind, ist am Ausgang A ein zweiter Spannungswert abnehmbar). Der Ausgang A erfüllt also eine Schmitt-Trigger-Funktion, d. h. das abgegebene Signal nimmt nur zwei stabile Spannungswerte an.

Weiter wird hierdurch (Schmitt-Trigger-Funktion am Ausgang A) eine sehr kurze Schaltzeit für das am Ausgang A abgegebene Ausgangssignal erreicht. Während dieser Schaltzeit ändert sich aber die am Eingang UV anliegende (und die Speicherbausteine versorgende) Betriebsspannung nur geringfügig, wodurch ein sicherer Betrieb (keine wesentlichen Spannungsänderungen an den Speicherbausteinen) gewährleistet ist.

Beim Abschaltvorgang, der am Eingang UV anliegenden Betriebsspannung kehren sich die Vorgänge des Einschaltvorganges sinngemäß um.

Solange die Betriebsspannung einen Wert besitzt, der kleiner ist als die Summe aus der Katodenspannung der Zenerdiode Z und der Basis-Emitter-Spannung des Transistors T1, (d. h. die Betriebsspannung hat die Schwellenspannung US noch nicht überschritten), ist am Ausgang A ein zweiter Spannungswert abnehmbar. Durch diesen zweiten Spannungswert sind die einleitend beschriebenen Speicherbausteine sperrbar. Weiter werden in diesem Zustand die Transistoren T2 und T3 gesperrt und die Quelle für die Pufferspannung nur mit einem sehr geringen Versorgungsstrom, d. h. Sperrstrom, belastet. Vorzugsweise werden für die Transistoren T2 und T3 Typen verwendet, die nur einen sehr geringen Sperrstrom benötigen, d. h. die hochohmig sperrende Halbleiterübergänge aufweisen.

## Patentansprüche

1. Schaltungsanordnung zur Überwachung einer Betriebsspannung (UV) für programmgesteuerte Schaltkreise, insbesondere Speicherbausteine, die bei Absinken der Betriebsspannung (UV) unter eine Schwellenspannung (US) den Speicherbaustein derart sperrt, daß die Daten-Ein/Ausgabe des Speicherbausteins unterbrochen und der Speicherbaustein über einen Ausgang (A) der Überwachungsschaltung in einen definierten Zustand gesetzt und mit einer von der Betriebsspannung (UV) unabhängigen Pufferspannung (UP) gleicher Polarität versorgt wird, dadurch gekennzeichnet, daß die Überwachungsschaltung eine erste Schaltstufe (T1, Z, R1 bis R5) mit einem Transistor (T1) aufweist, an dessen Emitter die Betriebsspannung (UV) angeschaltet und an dessen Kollektor eine Spannung (U) abnehmbar ist, daß die erste Schaltstufe weiter eine Zenerdiode (Z) aufweist, durch die für den Transistor (T1) die Schwellenspannung (US) einstellbar ist, und die bei deren Überschreitung, durch die Betriebsspannung (UV) die Spannung (U) an einen ersten Eingang einer zweiten Schaltstufe (T2, T3, R6 bis R10) abgibt, daß die zweite Schaltstufe (T2, T3, R6 bis R10) eine Schmitt-Trigger-Funktion erfüllt, bei der an einem weiteren Eingang zusätzlich die Pufferspannung (UP) anliegt und die bei Vorhandensein der Spannung (U) an ihrem Ausgang (A) einen ersten Spannungswert und sonst einen zweiten Spannungswert zum Sperren der Speicherbausteine abgibt, und daß in der zweiten Schaltstufe (T2, T3, R6 bis R10) im Zustand ihres zweiten Spannungswertes Transistoren (T2, T3) mit hochohmig sperrenden Halbleiterübergängen gesperrt sind.

2. Schaltungsanordnung nach Anspruch 1, dadurch gekennzeichnet, daß die Zenerdiode (Z) eine programmierbare Zenerdiode ist, deren Referenzeingang (R) mit einem Spannungsteilerpunkt (P) verbunden ist, der sich elektrisch zwischen der am Eingang anliegenden Betriebsspannung (UV) und einem Bezugspotential (OV) befindet.

3. Schaltungsanordnung nach Anspruch 1, dadurch gekennzeichnet, daß die zweite Schaltstufe (T2, T3, R6 bis R10) einen Transistor (T3) aufweist, durch den der Ausgang (A), der über einen Widerstand (R10) mit der an dem weiteren Eingang anliegenden Pufferspannung (UP) verbunden ist, gegen das Bezugspotential (OV) schaltbar ist, wobei der Transistor (T3) bei anliegender Spannung (U) über eine Spannungsteilerschaltung (R6, R7) leitend schaltbar ist, und daß die zweite Schaltstufe (T2, T3, R6 bis R10) einen weiteren Transistor (T2) aufweist, der das Schaltverhalten des Transistors (T3) beschleunigt.

4. Schaltungsanordnung nach Anspruch 3, dadurch gekennzeichnet, daß die Kollektor-Emitter-Strecke des weiteren Transistors (T2) dem Widerstand (R6) der Spannungsteilerschaltung (R6, R7) parallel geschaltet ist, an dem die Spannung (U) anliegt, wobei durch den weiteren Transistor (T2), dessen Basis über einen Widerstand (R8) mit dem Ausgang (A) verbunden ist, der Widerstand (R6) niederohmig überbrückbar ist.

## Claims

1. A supply voltage monitoring circuit for program-controlled arrangements, in particular storage modules, which blocks the storage module if the operating supply voltage (UV) falls below a threshold voltage (US), such that the data input/output of the storage module is interrupted and the storage module set in a determinate state via an output (A) of the monitoring circuit, and is supplied with a buffer voltage (UP) independent of the operating voltage (UV) but of the same polarity, characterised in that the monitoring circuit comprises a first switching stage (T1, Z, R1-R5) with a transistor (T1) to whose emitter the operating voltage (UV) is connected and from whose collector a voltage (U) can be tapped, that the first switching stage also comprises a Zener diode (Z) by which the threshold voltage (US) for the transistor (T1) can be adjusted and which, when said threshold voltage is overshot by the operating voltage (UV) emits the voltage (U) to a first input of a second switching stage (T2, T3, R6-R10), that the second switching stage (T2, T3, R6-R10) fulfills a Schmitt trigger function, the buffer voltage (UP) being connected to a further input, and the second switching stage emits a first voltage value from its output (A) when the voltage (U) is present and otherwise emits a second voltage value to block the storage modules, and that when the second switching stage (T2, T3, R6-R10) assumes the state of its second voltage value, transistors (T2, T3) therein have semiconductor junctions which present high-impedance blocking.

2. A circuit as claimed in Claim 1, characterised in that the Zener diode (Z) is a programmable Zener diode whose reference input (R) is connected to a voltage divider tapping (P) located electrically between the operating supply voltage (UV) connected to the input and reference potential (OV).

3. A circuit as claimed in Claim 1, characterised in that the second switching stage (T2, T3, R6-R10) comprises a transistor (T3) by which the output (A), connected via a resistor (R10) to the buffer voltage (UP) present at the further input, can be switched to the reference potential (OV), where the transistor (T3) can be switched conductive if the voltage (U) is connected via a voltage divider circuit (R6, R7), and that the second switching stage (T2, T3, R6-R10) comprises a further transistor (T2) which accelerates the switching behaviour of the transistor (T3).

4. A circuit as claimed in Claim 3, characterised in that the collector-emitter path of the further transistor (T2) is connected in parallel to that resistor (R6) of the voltage divider circuit (R6, R7) to which the voltage (U) is connected, whereby the resistor (R6) can be shunted in low-impedance fashion by the further transistor (T2), whose base is connected to the output (A) via a resistor (R8).

## Revendications

1. Montage pour contrôler une tension de service (UV) pour des circuits commandés par programme, notamment des modules de mémoire, et qui, lorsque la tension de service (UV) tombe au-dessous d'une tension de seuil (US), bloque le module de mémoire de telle sorte que l'entrée/la sortie de données du module de mémoire est interrompue et que le module de mémoire est placé, par l'intermédiaire d'une sortie (A) du circuit de contrôle, dans un état défini et est alimenté par une tension tampon (UP) indépendante de la tension de service (UV) et possédant la même polarité, caractérisé par le fait que le circuit de contrôle comporte un premier étage de commutation (T1, Z, R1 à R5) possédant un transistor (T1), à l'émetteur duquel la tension de service (UV) est appliquée et sur le collecteur duquel une tension (U) peut être prélevée, que le premier étage de commutation comporte en outre une diode Zener (Z), au moyen de laquelle la tension de seuil (US) pour le transistor (T1) est réglable et qui, dans le cas où cette tension est dépassée par la tension de service (UV), applique la tension (U) à une première entrée d'un second étage de commutation (T2, T3, R6 à R10), que le second étage de commutation (T2, T3, R6 à R10) assume la fonction d'un déclencheur de Schmitt et applique en outre la tension tampon (UP) à une autre entrée et, dans le cas de la présence de la tension (U) sur sa sortie (A), délivre une première valeur de tension où, sinon, une seconde valeur de tension pour réaliser le blocage du module de mémoire, et que dans le second étage de commutation (T2, T3, R6 à R10) dans l'état correspondant à la seconde valeur de tension de cet étage, des transistors (T2, T3) sont bloqués par des jonctions semiconductrices réalisant un blocage avec une forte valeur ohmique.

2. Montage suivant la revendication 1, caractérisé par le fait que la diode Zener (Z) est une diode Zener programmable, dont l'entrée de référence (R) est reliée au point (P) de division de tension, qui est situé du point de vue électrique entre la tension de service (UV) appliquée à l'entrée et un potentiel de référence (OV).

3. Montage suivant la revendication 1, caractérisé par le fait que le second étage de commutation (T2, T3, R6 à R10) contient un transistor (T3), à l'aide duquel la sortie (A), qui est placée, par l'intermédiaire d'une résistance (R10), à la tension tampon (UP) appliquée à l'autre entrée, peut être commutée sur le potentiel de référence (OV), auquel cas le transistor (T2) est placé à l'état conducteur par l'intermédiaire d'un circuit diviseur de tension (R6, R7), dans le cas où la tension (U) est appliquée, et que le second étage de commutation (T2, T3, R6 à R10) comporte un autre transistor (T2) qui accélère le comportement de commutation du transistor (T3).

4. Montage suivant la revendication 3, caracté

risé par le fait que la voie collecteur-émetteur de l'autre transistor (T2) est branchée en parallèle avec la résistance (R6) du circuit diviseur de tension (R6, R7), à laquelle est appliquée la tension (U), la résistance (R6) pouvant être shuntée selon une liaison de faible valeur ohmique par l'autre transistor (T2), dont la base est reliée à la sortie (A) par l'intermédiaire d'une résistance (R8).

# FIG 1

# FIG 2

# FIG 3